# FASCICULE DE BREVET EUROPEEN

(11) **EP 3 746 394 B1**
(45) Date de publication et mention de la délivrance du brevet: **26.10.2022**
(21) Numéro de dépôt: 19710010.0
(22) Date de dépôt: 24.01.2019
(51) Int. Cl.: B81C 1/00

(54) **PROCEDE D'ENCAPSULATION D'UN DISPOSITIF MICROELECTRONIQUE, COMPRENANT UNE ETAPE D'AMINCISSEMENT DU SUBSTRAT ET DU CAPOT D'ENCAPSULATION**
VERFAHREN ZUR VERKAPSELUNG EINER MIKROELEKTRONISCHEN VORRICHTUNG MIT EINEM SCHRITT ZUM DÜNNEN DES SUBSTRATS UND DER VERKAPSELUNGSABDECKUNG
METHOD FOR ENCAPSULATING A MICROELECTRONIC DEVICE, COMPRISING A STEP OF THINNING THE SUBSTRATE AND THE ENCAPSULATION COVER

(30) Priorité: 30.01.2018 FR 1850735
(43) Date de publication de la demande: 09.12.2020
(73) Titulaire: Commissariat à l'énergie atomique et aux énergies alternatives, 75015 Paris (FR)
(72) Inventeur: BEDJAOUI, Messaoud, 38340 VOREPPE (FR); SALOT, Raphaël, 38250 LANS-EN-VERCORS (FR)
(74) Mandataire: Brevalex
(86) Numéro de dépôt international: PCT/FR2019/050153
(87) Numéro de publication internationale: WO 2019/150019

(56) Documents cités:
- EP-A1- 2 581 338
- EP-A1- 2 677 538
- EP-A1- 3 157 050
- US-A1- 2005 263 866
- US-A1- 2013 277 777
- SALOT R ET AL: "Microbattery technology overview and associated multilayer encapsulation process", APPLIED SURFACE SCIENCE, ELSEVIER, AMSTERDAM, NL, vol. 256, no. 3, 15 novembre 2009 (2009-11-15), pages S54-S57, XP026776645, ISSN: 0169-4332, DOI: 10.1016/J.APSUSC.2009.09.086 [extrait le 2009-10-04]

## Description

La présente invention se rapporte à un procédé d'encapsulation d'un dispositif microélectronique, disposé sur un substrat de support, avec un capot d'encapsulation, le procédé comprenant une étape d'amincissement du substrat de support et/ou du capot d'encapsulation.

La présente invention concerne également une structure mircroélectronique, obtenue par un tel procédé.

Ces dernières années, les composants microélectroniques, et plus particulièrement, les microbatteries tout solides en couches minces sont devenues incontournables dans le développement des systèmes intelligents embarqués. Ces systèmes intelligents sont, par exemple, utilisés, dans les applications dites internet des objets (« Internet of Things »), le stockage d'énergie, la récupération de l'énergie, l'électronique organique et inorganique, ou encore le domaine de la puissance.

Le développement de ces systèmes intelligents doit mener vers une miniaturisation des composants microélectroniques, et parallèlement à l'utilisation de substrats de support de plus en plus fins. Les substrats utilisés pour ces systèmes doivent être fins (typiquement ayant une épaisseur inférieure à 100µm) voire même ultrafins (épaisseur inférieure à 50µm).

Les dispositifs microélectroniques, et notamment les microbatteries au lithium, présentent une très forte sensibilité aux éléments atmosphériques tels que l'oxygène et la vapeur d'eau. Ces dispositifs doivent donc être encapsulés pour garantir leur intégrité électronique ou électrochimique mais aussi mécanique dans le temps. Les performances des systèmes d'encapsulation sont fréquemment exprimées en termes de vitesses de transmission de la vapeur d'eau (WVTR pour « Water Vapor Transmission Rate ») ou encore en vitesse de transmission de l'oxygène (OTR pour « Oxygen Transmission Rate »). Dans le cas particulier des microbatteries au lithium, les niveaux WVTR et OTR requis sont respectivement de l'ordre de 10⁻⁴ g/m²/j et de 10⁻⁴ cm³/m²/j. Sur le plan pratique, pour répondre aux critères de miniaturisation des dispositifs microélectroniques, le capot doit également être fin ou ultrafin.

Cependant, dans la pratique, les substrats et/ou les capots sont soumis à de nombreuses étapes technologiques (transfert, dépôt, gravure, nettoyage...). Or, la manipulation des substrats fins est très contraignante à cause de leurs fragilités mécaniques.

Afin de remédier à cette problématique, les substrats fragiles peuvent, classiquement, être fixés temporairement sur des supports solides pour faciliter leur manipulation et leur maniement durant les étapes technologiques, comme par exemple décrit dans le document WO-A-2015/092254. Cependant, cette solution nécessite de réaliser une étape assez complexe de désolidarisation du substrat fin de son support rigide à la fin du procédé, par exemple, en insérant une lame entre le substrat et le support temporaire ou encore en appliquant une force de cisaillement ou de traction sur le substrat. De plus, certaines solutions de collage temporaire ne sont pas adaptées aux dispositifs microélectroniques dont les procédés nécessitent des budgets thermiques avec des températures supérieures à 300°C. Finalement, de telles étapes de collage et de désolidarisation conduisent à une augmentation des couts de fabrication et/ou des délais de production. Le document US 2013/277777 A1 divulgue un procédé d'encapsulation d'un dispositif microélectronique, disposé sur un substrat de support, avec un capot d'encapsulation comprenant les étapes successives suivantes : a) fourniture d'un substrat de support, en un premier matériau, comprenant une première face principale sur laquelle est disposée un dispositif microélectronique, et une seconde face principale opposée à la première face principale, b) dépôt d'une couche de collage, en un deuxième matériau, sur la première face du substrat, autour du dispositif microélectronique, c) positionnement d'un capot d'encapsulation, en un troisième matériau, comprenant une première face principale et une seconde face principale, opposée à la première face principale, sur la couche de collage, de manière à fixer la première face principale du capot d'encapsulation sur le substrat de support, et de manière à encapsuler le dispositif microélectronique, d) amincissement, par gravure chimique, de la seconde face principale du substrat de support et de la seconde face principale du capot d'encapsulation jusqu'à une épaisseur inférieure à 200 µm. Ce document divulgue également une structure microélectronique comprenant un dispositif microélectronique disposé sur un substrat de support, en un premier matériau, ledit dispositif étant entouré par une couche de collage, en un deuxième matériau, sur laquelle est fixé un capot d'encapsulation, en un troisième matériau, le capot d'encapsulation et le substrat de support ayant une épaisseur inférieure à 200 µm.

### EXPOSÉ DE L'INVENTION

C'est, par conséquent, un but de la présente invention de proposer un procédé d'encapsulation remédiant aux inconvénients de l'art antérieur et, en particulier, de proposer un procédé d'encapsulation de dispositifs microélectroniques sensibles à l'air et/ou aux températures élevées avec un substrat et/ou un capot fin ou ultrafin, le procédé devant être facile à mettre en œuvre et ne nécessitant pas d'étape de désolidarisation comme dans l'art antérieur.

Ce but est atteint par un procédé d'encapsulation d'un dispositif microélectronique, disposé sur un substrat de support, avec un capot d'encapsulation comprenant les étapes successives suivantes :
a) fourniture d'un substrat de support, en un premier matériau, comprenant une première face principale sur laquelle est disposée un dispositif microélectronique, et une seconde face principale opposée à la première face principale,
b) dépôt d'une couche de collage, en un deuxième matériau, sur la première face du substrat, autour du dispositif microélectronique,
c) positionnement d'un capot d'encapsulation, en un troisième matériau, comprenant une première face principale et une seconde face principale, opposée à la première face principale, sur la couche de collage, de manière à fixer la première face principale du capot d'encapsulation sur le substrat de support, et de manière à encapsuler le dispositif microélectronique,
d) amincissement, par gravure chimique, de la seconde face principale du substrat de support et de la seconde face principale du capot d'encapsulation jusqu'à une épaisseur inférieure à 200µm, de préférence, inférieure ou égale à 100µm et encore plus préférentiellement inférieure à 50µm, la seconde face principale (202) du substrat de support (200) et la seconde face principale (402) du capot d'encapsulation (400) étant amincies simultanément lors de l'étape d).

Le procédé selon l'invention est simple à mettre en œuvre, il nécessite peu d'étapes technologiques. Le procédé de l'invention ne met pas en œuvre des étapes de solidarisation temporaire et de désolidarisation. A la fin du procédé d'encapsulation, le dispositif microélectronique est encapsulé, d'une part, avec un substrat, pouvant être fin ou ultrafin, et, d'autre part, par un capot pouvant être fin ou ultrafin.

Par fin, on entend une épaisseur inférieure à 200µm, et de préférence inférieure à 100µm, et par ultrafin, on entend une épaisseur inférieure à 50µm.

Le procédé de la présente invention permet d'obtenir des dispositifs miniaturisés dont les dispositifs microélectroniques sont protégés de l'air et de ses oxydants.

L'étape d) d'amincissement est réalisée par gravure chimique. Les conditions de gravure sont bien contrôlées par rapport à une gravure mécanique, ce qui évite la formation de défauts dans les dispositifs microélectroniques.

Avantageusement, le premier matériau et/ou le troisième matériau sont choisis parmi le verre et le silicium. Ces matériaux présentent de bonnes propriétés barrières.

Selon une première variante avantageuse, le premier matériau et le troisième matériau sont identiques. L'amincissement du substrat support et du capot d'encapsulation peuvent être réalisés simultanément et à la même vitesse de gravure, par exemple, en immergeant, ou aspergeant, l'ensemble avec une solution de gravure chimique. L'amincissement peut être contrôlé en fonction du temps d'immersion ou d'aspersion et de la composition chimique des liquides utilisés.

Selon une deuxième variante avantageuse, le premier matériau et le troisième matériau sont différents. Il est possible de graver uniquement le capot d'encapsulation ou le substrat de support, de les graver successivement ou de les graver simultanément à des vitesses différentes.

Selon un mode de réalisation particulièrement avantageux, lors de l'étape b), la couche de collage recouvre totalement le dispositif microélectronique.

Selon un autre mode de réalisation particulièrement avantageux, lors de l'étape b), la couche de collage forme un cordon de scellement autour du dispositif microélectronique.

Avantageusement, dans ce mode de réalisation avantageux, le cordon de scellement est en pâte de verre, et le cordon de scellement est entouré par une couche de protection en un quatrième matériau.

Avantageusement, le deuxième matériau et/ou le quatrième matériau est un matériau polymère choisi parmi les époxydes, les éthers, les polysiloxanes, les acryliques, un de leurs copolymères, et le polyéthylène téraphtalate.

Avantageusement, à l'issue de l'étape d), le capot d'encapsulation et/ou le substrat de support ont une épaisseur inférieure ou égale à 100µm, et de préférence, inférieure à 50µm.

Avantageusement, le dispositif microélectronique est un dispositif électrochimique, telle qu'une microbatterie au lithium.

Avantageusement, plusieurs dispositifs microélectroniques, identiques ou différents, sont disposés sur la première face du substrat de support et/ou sur la première face principale du capot d'encapsulation.

Le procédé selon l'invention autorise plusieurs configurations en termes de nombre et de positionnement de dispositifs microélectroniques. Par exemple, il est possible d'empiler deux microbatteries.

L'invention concerne également une structure microélectronique, obtenue par le procédé tel que défini précédemment, comprenant un dispositif microélectronique, par exemple un dispositif électrochimique, telle qu'une microbatterie au lithium, disposé sur un substrat de support, en un premier matériau, le dispositif étant entouré par une couche de collage, en un deuxième matériau, sur laquelle est fixé un capot d'encapsulation, en un troisième matériau, le capot d'encapsulation et le substrat de support ayant une épaisseur inférieure à 200µm, de préférence, inférieure ou égale à 100µm et encore plus préférentiellement inférieure à 50µm.

Selon l'invention, la couche de collage recouvre totalement le dispositif microélectronique, ou la couche de collage forme un cordon de scellement, en pâte de verre, autour du dispositif microélectronique, le cordon de scellement étant entouré par une couche de protection en un quatrième matériau.

Les caractéristiques liées au procédé se retrouvent pour la structure microélectronique.

### BRÈVE DESCRIPTION DES DESSINS

La présente invention sera mieux comprise sur la base de la description qui va suivre et des dessins en annexe sur lesquels :
- la figure 1, est une représentation schématique, en coupe et de profil, d'une microbatterie sur un substrat support, selon un mode de réalisation particulier de l'invention,
- la figure 2 est une représentation schématique, en trois dimensions, d'un substrat support sur lequel sont disposées plusieurs microbatteries, selon un autre mode de réalisation particulier de l'invention,
- les figures 3A à 3C représentent le positionnement d'une couche de collage sur un substrat comportant au moins un dispositif microélectronique, selon différents modes de réalisation du procédé de l'invention,
- les figures 4A à 4C représentent au moins un dispositif microélectronique, sur un substrat, encapsulé par un capot de protection, selon différents modes de réalisation du procédé de l'invention,
- les figures 5 et 6 représentent différentes étapes du procédé d'encapsulation de dispositifs microélectroniques, selon un mode de réalisation particulier de l'invention,
- les figures 7A à 7C représentent un système miniaturisé comprenant un dispositif microélectronique, sur un substrat, encapsulé par un capot de protection, et des contacts électriques, selon différents modes de réalisation du procédé de l'invention.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et pouvant se combiner entre elles.

### EXPOSÉ DÉTAILLÉ DE MODES DE RÉALISATION PARTICULIERS

Le procédé d'encapsulation d'au moins un dispositif microélectronique, par exemple, sensible à l'air (au dioxygène et à la vapeur d'eau), avec un capot d'encapsulation, va maintenant être décrit. Le procédé comprend les étapes successives suivantes :
a) fourniture d'un substrat de support 200, en un premier matériau, comprenant une première face principale 201 sur laquelle est disposée un dispositif microélectronique 300, et une seconde face principale 202 opposée à la première face principale 201,
b) dépôt d'une couche de collage 500, en un deuxième matériau, sur la première face 201 du substrat de support 200, autour du dispositif microélectronique 300,
c) positionnement d'un capot d'encapsulation 400, en un troisième matériau, comprenant une première face principale 401 et une seconde face principale 402, opposée à la première face principale 401, sur la couche de collage 500, de manière à fixer la première face principale 401 du capot d'encapsulation 400 sur le substrat de support 200, et de manière à encapsuler le dispositif microélectronique 300,
d) amincissement de la seconde face principale 202 du substrat de support 200 et/ou de la seconde face principale 402 du capot d'encapsulation 400 jusqu'à une épaisseur inférieure à 200µm, par exemple, jusqu'à une épaisseur inférieure ou égale à 100µm et de préférence inférieure à 50µm.

### Substrat de support 200 et capot d'encapsulation 400 :

Le substrat de support 200, aussi appelé substrat hôte ou substrat support, fourni à l'étape a), est de préférence un substrat rigide.

Le capot d'encapsulation 400, fourni à l'étape c), est de préférence un capot d'encapsulation rigide.

Par rigide, nous entendons tout support aisément utilisable en microélectronique ayant une épaisseur supérieure à 200µm. Par exemple, le substrat 200 et/ou le capot d'encapsulation 400 ont initialement une épaisseur supérieure à 250µm, par exemple de 500µm. De préférence, le substrat 200 et le capot 400, fournis aux étapes a) et c), ont initialement une épaisseur supérieure à 200µm . Selon l'invention ils sont tous les deux amincis lors de l'étape d) .

Le substrat 200 et le capot d'encapsulation 400 peuvent avoir des épaisseurs identiques ou différentes. L'épaisseur du capot peut être inférieure à celle du substrat 200 ou inversement. Cette éventuelle configuration permet de réaliser des dispositifs microélectroniques dont le capot d'encapsulation est plus fin que le substrat 200 ou inversement.

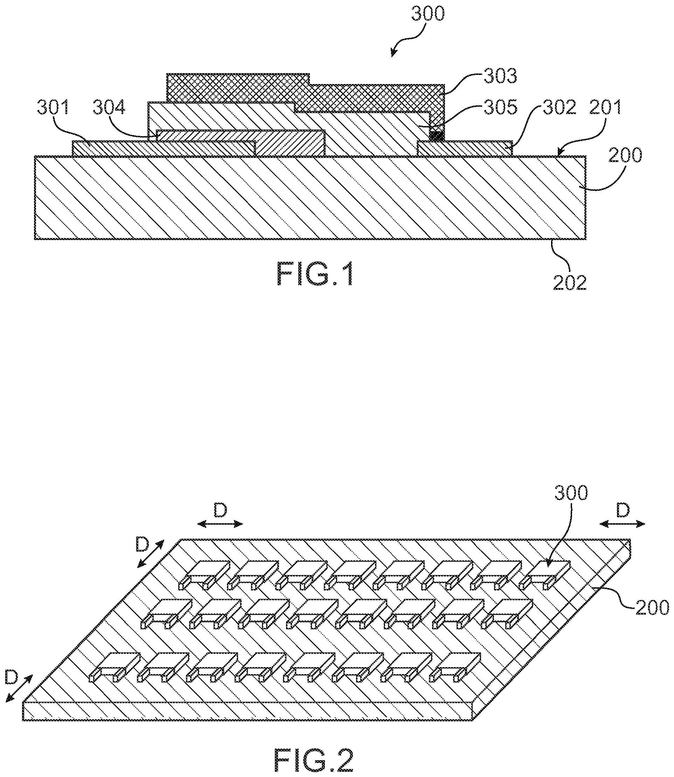

Comme représenté sur les figures 1 et 2, le substrat 200 comporte une première face principale 201, et une seconde face principale 202. La première face comprend au moins un dispositif microélectronique 300. Il s'agit de la face dite active. Le substrat comprend également une face latérale allant de la première face à la deuxième face.

Le capot 400 comprend une première face principale 401, et une seconde face principale 402, ainsi qu'une face latérale allant de la première face 401 à la deuxième face 402.

Le substrat 200 et le capot d'encapsulation 400 peuvent avoir des formes géométriques identiques ou différentes. Il est possible par exemple d'utiliser des formats circulaires type wafers ou des formats feuilles, c'est-à-dire rectangulaires.

Le substrat support 200 est en un matériau identique ou différent de celui du capot d'encapsulation.

Le substrat 200 et/ou le capot d'encapsulation 400 ont, avantageusement, les performances requises pour l'encapsulation des microbatteries au lithium. Ils sont élaborés en un matériau ayant des niveaux de barrière WVTR et OTR au plus, respectivement, de 10⁻⁴ g/m²/j et de 10⁻⁴ cm³/m²/j pour garantir des propriétés d'étanchéité suffisantes à la cellule de scellement vis-à-vis de l'air et de la vapeur d'eau.

Le substrat support 200 et le capot d'encapsulation 400 peuvent être choisis parmi les verres, le silicium (monocristallin ou polycristallin), les céramiques, le mica, et le quartz. De préférence, ils sont en verre. Ils peuvent être en un verre de la même famille ou de familles différentes.

Les verres peuvent être des borosilicates (comme les D263⁹LA, D263^{®}M, D263^{®}T, MEMpax^{®} ou encore le Borofloat^{®} commercialisés par la société SCHOTT^{®}), des dérivés de borosilicates comme les verres alkali-free borosilicates (AF32^{®}, AF45, Corning^{®}Willow....) ou encore des verres de type boro-aluminosilicates alcalins (« alkaline earth boro-aluminosilicates ») commercialisés par exemple par les sociétés Corning Lotus^{™}, EAGLE XG^{®}....

De préférence, le capot 400 est transparent aux longueurs d'onde des lasers classiquement utilisés pour figer des cordons de scellement (typiquement pour des cordons de scellement en pâte de verre, autour de 940nm). Par transparent, on entend que le capot laisse passer au moins 50% de la lumière émise par le laser de manière à pouvoir chauffer le cordon de scellement à travers le capot 400.

De préférence, le substrat de support 200 et le capot d'encapsulation 400 ont des épaisseurs identiques et sont en un même matériau.

### Dispositif microélectronique 300 à encapsuler :

Le procédé permet d'encapsuler simultanément un dispositif ou plusieurs dispositifs microélectroniques 300. Le dispositif électronique 300, ou composant microélectronique, a une épaisseur allant de 5µm à 30µm, et de préférence de 10 à 15µm.

Sur la première face principale 201 du substrat 200, peuvent être disposés un ou plusieurs dispositifs électroniques 300 de même nature ou de natures différentes. Cette configuration offre la possibilité de réaliser des empilements fonctionnels par intégration 3D.

Le capot d'encapsulation 400 peut être un élément passif ou actif, i.e. la première face 401 du capot 400 peut comporter des dispositifs microélectroniques 300 de même nature ou de natures différentes de celles du substrat 200, pouvant remplir d'autres fonctionnalités.

Le substrat support 200 et/ou le capot d'encapsulation 400 peuvent comporter un ou plusieurs dispositifs microélectroniques 300 pour multiplier les performances électrochimiques par une mise en parallèle ou en série des composants microélectroniques. Les dispositifs microélectroniques peuvent être, par exemple, choisis parmi les microbatteries, les capacités, les supra-capacités, les composants photovoltaïques, les transistors, les antennes ou tout autre dispositif jugé nécessaire pour la réalisation d'objets connectés.

Avantageusement, les composants microélectroniques du substrat et du capot sont positionnés en vis-à-vis afin de pouvoir les associer selon une approche d'empilement 3D.

Par composant microélectronique 300, on entend, par exemple, un MEMS (microsystème électromécanique), un MOEMS (microsystème opto-électromécanique), ou encore un micro-détecteur infrarouge, ou même un transistor. Plus généralement, par composant microélectronique, on entend tout dispositif destiné à être encapsulé sous atmosphère contrôlée.

Par la suite, même si la description fait en particulier référence à une microbatterie, et plus particulièrement à une microbatterie au lithium, l'invention est transposable à tout composant microélectronique nécessitant une protection vis-à-vis des oxydants. Il peut s'agir, par exemple d'un empilement capacitif ou d'un composant électrochrome.

Le composant microélectronique 300, ici la microbatterie, est disposée sur une des faces 201 (première face principale) du substrat 200. La microbatterie comprend des collecteurs de courant cathodique 301 et anodique 302, disposés sur le substrat 200. Deux couches actives, l'une formant l'électrode négative 303, et l'autre formant l'électrode positive 304, sont séparées par une couche d'électrolyte 305. Chaque couche active 303, 304 est en contact avec l'un des collecteurs de courant 301, 302.

Les collecteurs de courant 301, 302 sont, avantageusement, métalliques. A titre illustratif, ils peuvent être en titane, or, aluminium, platine, ou en tungstène.

L'électrode positive 304 (cathode) est en un matériau ayant une bonne conductivité électronique et ionique (par exemple TiOS, TiS₂, LiTiOS, LiTiS₂, LiCoO₂, V₂O₅...). On choisira de préférence une électrode positive en oxyde de cobalt. Ce type de cathode est considéré comme l'une des couches les plus performantes pour les microbatteries et en même temps les plus contraintes lors des étapes de réalisation. En effet, les contraintes mécaniques engendrées après formation de la couche cathodique (Coefficient d'expansion thermique entre 10×10⁻⁶/° C et 15×10⁻⁶/°C et un module de Young entre 100 et 500 GPa) peuvent influer sur le comportement des substrats rigides une fois amincis.

L'électrolyte 305 est un isolant électronique avec une forte conductivité ionique (par exemple LiPON, LiPONB, LiSiCON...).

L'électrode négative 303 (anode) est une couche qui peut être du lithium métallique ou un matériau lithié.

Optionnellement et selon les configurations, les couches actives peuvent être protégées par un système d'encapsulation primaire, non représenté, comprenant une ou plusieurs couches barrières élémentaires dont le rôle principal est de garantir une intégrité des dispositifs microbatteries pendant les différentes phases du procédé.

La microbatterie sera réalisée par les techniques connues de l'homme du métier.

Les composants microélectroniques 300 sont positionnés en dehors du contour périphérique du substrat support et/ou du capot d'encapsulation pour les protéger, lors de l'étape de gravure, notamment dans le cas d'une gravure chimique (où une rectification latérale peut voir lieu). Avantageusement, cet espace sera choisi de manière à être au moins égal au double de l'épaisseur du substrat rigide et/ou du capot d'encapsulation. Ce contour est représenté par la lettre D sur les figures 2, 3A, 4A et 4C.

### Couche de collage 500 :

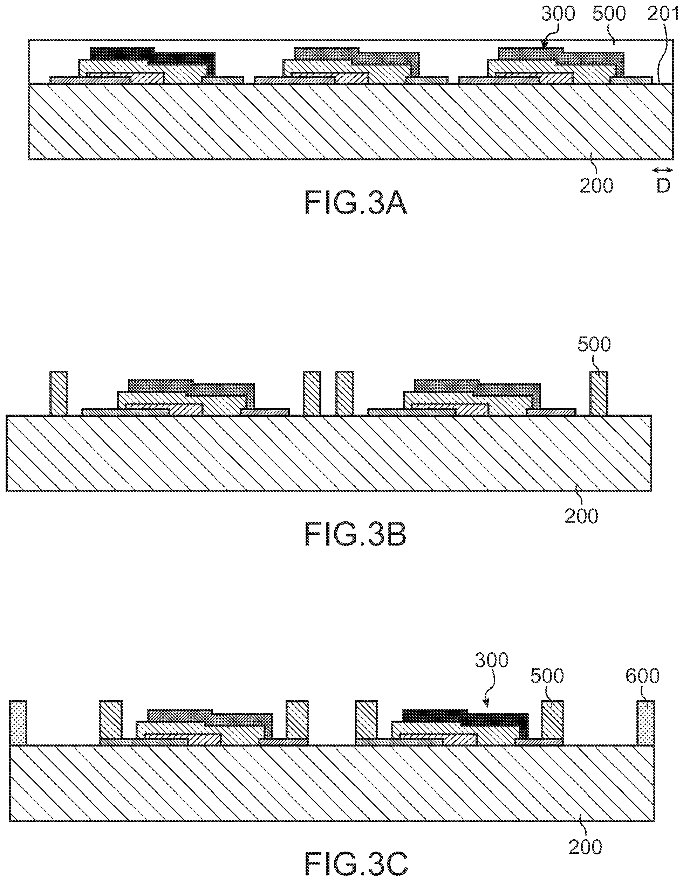

Comme représenté sur les figures 3A, 3B et 3C, lors de l'étape b), une couche de collage 500 est positionnée sur la première face 201 du substrat support 200, de part et d'autre du dispositif microélectronique 300.

La couche de collage 500 a une épaisseur supérieure ou égale à celle du ou des composants microélectroniques 300 à encapsuler.

La couche de collage 500 entoure le composant microélectronique 300, de manière à former, après le report du capot d'encapsulation 400 une barrière de protection autour du composant microélectronique 300.

La couche de collage 500 a des propriétés de résistance par rapport à la gravure, et notamment par rapport à la solution de gravure chimique, pour empêcher le risque d'infiltration des produits chimiques vers les couches actives lors de l'étape d'amincissement.

De façon générale, le rôle de la couche de collage 500 est triple. En effet, elle permet en premier lieu de coller le capot d'encapsulation avec le substrat 200 grâce à ses performances d'adhésivité. Elle assure aussi la fonctionnalité de protection latérale des microbatteries des possibles infiltrations des solutions de gravure chimique en raison des propriétés de résistance chimique aux acides. En dernier lieu la couche, par son caractère polymère, offre une solution d'absorption mécanique des mouvements d'expansion volumique engendrés par le fonctionnement de la microbatterie correspondant à l'insertion/désinsertion du lithium lors des cycles de charge et de décharge.

Selon une première variante de l'invention, représenté sur la figure 3A, la couche de collage 500 peut recouvrir totalement la première face 201 du substrat 200. Par totalement, on entend au moins 90% de la surface de la première face 201 du substrat 200.

Pour cela, lors de l'étape b), la couche de collage 500 est étalée sur toute la surface du substrat 200 comportant le dispositif microélectronique, par toute technique adaptée. Différentes techniques de dépôt peuvent être utilisées pour déposer la couche de collage 500. Pour les dépôts en voie liquide, pour former des couches de collage déposées pleine plaque, on privilégiera la technique de dépôt à la tournette (« spin coating »). La solution aura, avantageusement, une viscosité de moins de 1000cPs. En modifiant la vitesse et le temps de rotation de la tournette, on pourra faire varier l'épaisseur de la couche de collage 500. Par exemple, dans le cas d'une couche en époxyde OG198-54, l'épaisseur totale pourra varier de 1 à 25 µm.

La couche de collage 500 est, de préférence, obtenue par polymérisation d'un polymère photopolymérisable, par exemple sous UV, ou thermodurcissable. Il peut s'agir d'un polymère à faible viscosité (par exemple, ayant une viscosité inférieure à 2000 cPs).

Le polymère est de la famille des époxydes, des éthers, des silicones, des acrylates ou d'un de leurs copolymères. On pourra choisir les polymères commerciaux de la série Epo-Tek réticulés par UV ou par voie thermique comme les produits (OG198-54, UD1355, OG653, UG1192, T7110, H70E...).

Alternativement, la couche de collage 500 peut être un film adhésif. Le film adhésif est laminé sur le substrat. Le film adhésif sera choisi en fonction de ses propriétés de collage, de conformabilité, d'isolation électrique et/ou de compatibilité chimique avec les couches actives de la microbatterie. Il peut être sensible à la pression (« Pressure sensitive Adhesive »), à la température ou aux rayons UV. Il peut être obtenu à partir de films polymères à base d'acrylique, de silicone, de caoutchouc ou d'un de leurs mélanges. A titre indicatif et non exhaustif, on pourra utiliser les adhésifs isolants commercialisés par Tesa, Henkel, 3M, Norland ou Novagard. Par exemple, on utilisera une couche d'adhésif Tesa61562 d'une épaisseur de 25µm commercialisés par la société Tesa pour réaliser la solidarisation du substrat et du capot. La solidarisation peut être réalisée par un procédé de laminage à une température de 90°C avec une pression supérieure à 1 bar et une vitesse inférieure à 3 m/mn.

Un ou plusieurs adhésifs peuvent être utilisés pour former la couche de collage 500.

La couche de collage 500 peut également comprendre des inclusions particulaires et/ou des absorbeurs (getters) d'oxygène et d'eau pour améliorer leurs étanchéités.

La couche de collage 500, déposée à l'étape b), peut être structurée par des techniques de photolithographie ou de gravure laser.

Selon une deuxième variante de l'invention, représenté sur les figures 3B et 3C, la couche de collage 500 peut recouvrir uniquement partiellement la première face 201 du substrat 200. Selon cette deuxième variante de l'invention, la couche de collage 500 forme un cordon de scellement autour du dispositif microélectronique.

Le cordon de scellement 500 est positionné de telle sorte qu'une fois que le capot 400 sera reporté sur le substrat 200, le cordon 500 entoure le composant microélectronique 300 à encapsuler pour l'isoler de l'atmosphère. Dans le cas de microbatteries 300, le cordon de scellement 500 est, avantageusement, disposé au niveau des collecteurs de courant 301, 302 pour gagner de la place et faciliter la miniaturisation (figure 3C).

Le cordon de scellement 500 est électriquement non conducteur.

Le cordon de scellement 500 peut être en un matériau polymère.

Le cordon de scellement 500 est, avantageusement, réalisé à partir d'une pâte de verre. Les pâtes de verre comprennent des particules de verre dispersées dans un liant organique. Par exemple, une pâte de verre peut contenir au moins 70% massique de particules de SiO₂. Le liant organique est détruit en chauffant la pâte de verre. Les pâtes de verre peuvent être vitrifiées à des températures allant de 300°C à 400°C. Les pâtes de verre vitrifiées forment les soudures. Elles maintiennent mécaniquement le capot 400 au substrat 200. Elles sont également étanches vis-à-vis des oxydants de l'air.

Les cordons en verre fritté présentent généralement des propriétés barrières à l'air nettement supérieures à celles des colles.

A titre d'exemple, les pâtes de verre commercialisées par Namics sous la référence DM2700P/H848, commercialisées par AGC (Asahi Glass Company) sous les références 4290D1, 5115HT1, TNS062-Z27-TP12, 5290D1 ou encore commercialisées par Corning sous la référence Vita^{™} peuvent être envisagées pour la réalisation du cordon de scellement 500. Ces pâtes de verre sont compatibles avec les matériaux en verre choisis pour le substrat 200 et/ou pour le capot 400 de fermeture et d'encapsulation.

De préférence, le cordon 500 est élaboré à partir de la pâte DM2700P/H848. En plus de ses propriétés intrinsèques barrières vis-à-vis des espèces oxydantes (valeurs de WVTR et de OTR de l'ordre de 10⁻⁶ gm⁻²j⁻¹ et de 10⁻⁶ cm³/m²/j), ce produit possède de bonnes propriétés thermiques (CET de 7,7×10⁻⁶ K⁻¹ à 20°C) très proches des matériaux en verre (CET de 7,2×10⁻⁶ K⁻¹ à 20°C). En outre, ce produit peut être scellé avec des temps relativement courts sous irradiation laser (de l'ordre de 60 secondes), ce qui limite les risques de propagation de chaleur durant l'étape de scellement.

Alternativement, d'autres produits commercialisés par AGC sous la référence 5115HT1 ou par Corning sous la référence Vita^{™} peuvent être utilisés dans la réalisation du cordon de scellement 500.

Le cordon de scellement 500 a une épaisseur qui peut varier de quelques microns à une centaine de microns. Par épaisseur, on entend la dimension perpendiculaire à l'empilement substrat/capot. Son épaisseur sera choisie par l'homme du métier afin de créer, une fois le procédé d'encapsulation achevé, une cavité entre le substrat 200 et le capot d'encapsulation 400 suffisante pour ne pas perturber les cycles de charge et de décharge des microbatteries. Ces cycles, qui correspondent à un phénomène d'insertion/désinsertion du lithium entre les deux électrodes, se traduisent généralement par des phénomènes d'expansion volumique des électrodes. Il est donc primordial de former une cavité suffisamment haute pour un libre mouvement vertical des électrodes. La hauteur d'une telle cavité dépend de la différence de hauteur entre l'épaisseur du cordon 500 et celle de l'empilement des couches actives de la batterie 300. Typiquement, la valeur minimale de cette hauteur est fixée autour de 5% de la valeur de l'épaisseur totale de la microbatterie 300. La largeur et l'épaisseur du cordon de scellement 500 sont optimisées en fonction de la taille des éléments à protéger afin de réduire efficacement l'encombrement de la surface des cordons 500 par rapport à la surface totale du dispositif microbatterie. La largeur du cordon de scellement 500 sera d'au moins 100µm, dans le cas d'un substrat 200 avec des microbatteries 300. De telles dimensions satisfont aux propriétés d'étanchéité et de tenue mécanique requises. On utilisera, par exemple, une épaisseur de 50µm et une largeur de 100µm.

Le cordon 500 peut être formé sur le substrat 200 et/ou sur le capot d'encapsulation 400 en utilisant toute technique adaptée (dispense, par exemple par application au pinceau, à la brosse, sérigraphie ou autres).

Lorsque le cordon de scellement est en pâte de verre, le cordon de scellement 500 est entouré par une couche de protection 600 en un quatrième matériau (figure 3C). La couche de protection 600 forme une couronne autour du cordon de scellement 500 de manière à le protéger lors de la gravure chimique.

Cette couche de protection 600, sous la forme d'un anneau périphérique, est, de préférence, en un matériau polymère judicieusement choisi en raison de sa résistance chimique par rapport à l'étape de gravure. La couche de protection 600 latérale est, de préférence, en un polymère choisi parmi les époxydes, les silicones, ou encore il peut s'agir d'un adhésif PSA, ou d'un adhésif UV. On pourra également choisir du polyéthylène téréphtalate (PET).

Après l'étape de dépôt de la pâte de verre, le cordon de scellement 500 obtenu est, avantageusement, vitrifié en réalisant un traitement thermique. La température du traitement est, par exemple, de 100°C à 160°C, par exemple de l'ordre de 150°C. La durée du traitement va, par exemple, de quelques minutes à une heure, par exemple de l'ordre de 30 minutes. Ce traitement thermique permet, avantageusement, de dégazer les solvants présents initialement dans la pâte de verre (10 à 15% en volume).

### Positionnement du capot d'encapsulation 400 :

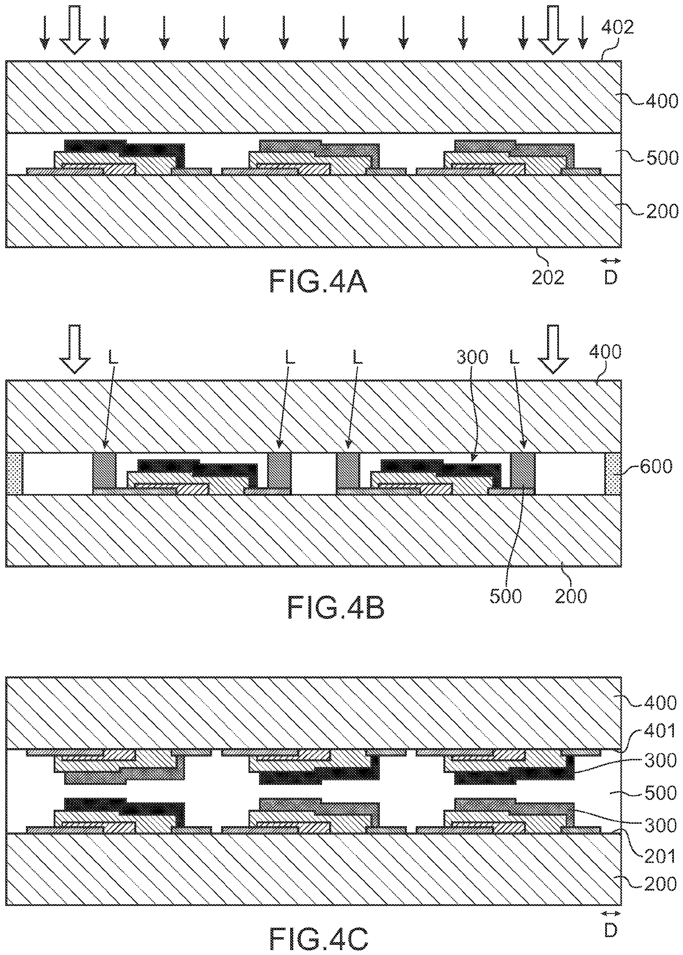

Comme représenté sur les figures 4A, 4B et 4C, lors de l'étape c), le capot d'encapsulation 400 est positionné au-dessus du substrat. Une force F, de quelques newtons, par exemple d'environ 2 N, représentées par les flèches larges sur les figures 4A et 4B, peut être appliquée lors du positionnement du capot 400 pour garantir un contact homogène entre la couche de collage 500 et le substrat support 200 et/ou le capot d'encapsulation 400.

Une irradiation avec une source ultra-violette (représentées par les flèches fines sur la figure 4A) et/ou un chauffage thermique peut être utilisé pour consolider et figer la couche de collage 500, permettant ainsi la fixation mécanique du support au capot par l'intermédiaire de la couche de collage 500.

Par exemple, la solidarisation de la structure de base est assurée par une insolation UV à travers le capot d'encapsulation en utilisant une dose d'environ 100mWatt/cm² dans la gamme de longueur d'onde entre 280nm-800nm pendant 2mn. La réticulation UV peut être complétée par un recuit thermique, par exemple, d'une durée de 20mn et à une température de 100°C.

Les cordons de scellement 500 sont, avantageusement, exposés à un rayonnement laser à travers la face supérieure 402 du capot d'encapsulation 400 à l'aide d'un rayonnement laser pour chauffer localement les cordons de scellement (figure 4B). Le rayonnement laser est représenté par les flèches L. Le chauffage par irradiation laser est particulièrement avantageux puisqu'il ne nécessite pas de chauffer l'ensemble du substrat 200 et du capot 400. Il permet de chauffer localement les cordons 500 jusqu'à plus de 300°C, par exemple de 300°C à 400°C de manière à les vitrifier et à former les soudures, nécessaires au scellement. Le capot 400 est ainsi scellé de façon permanente sur le substrat 200 contenant les composants 300.

On choisira avantageusement une fibre laser pour localiser encore plus le rayonnement.

L'augmentation de la température rend les matériaux des cordons 500 plus aisément déformables par effet de fusion, et augmente la surface de contact entre le cordon 500 et le capot 400 ou le substrat 200. La température peut atteindre, localement, plus de 500°C lors de l'irradiation laser.

Les caractéristiques principales des lasers seront choisies par l'homme du métier en fonction de la nature de la pâte de verre employée pour le cordon 500 et les propriétés optiques du capot 400. Plus particulièrement, la gamme de longueurs d'onde de lasers disponible va de l'infrarouge (lasers CO₂, Nd:YAG, etc.) à la lumière ultraviolette (laser Excimer et des harmoniques de Nd: YAG). Ceci offre la possibilité de choisir la longueur d'onde la plus appropriée pour garantir un collage efficace des pâtes de verre. Par exemple, un rayonnement à une longueur d'onde se situant dans le domaine du proche infrarouge, typiquement à 940 nm, peut être choisi.

Le cordon 500 peut être soumis à une illumination laser pendant une durée allant de quelques dizaines de secondes à quelques centaines de secondes.

Le scellement peut être réalisé par balayage laser. Le faisceau peut se déplacer à une vitesse de quelques mm/s, par exemple de l'ordre de 2mm/s.

Par exemple, une illumination laser à une puissance de 80W pendant 60s, avec un déplacement de 2mm/s est suffisante pour engendrer l'abrasion du cordon 500 permettant de sceller de façon permanente le capot d'encapsulation avec le substrat rigide contenant les dispositifs à encapsuler.

Cette étape permet de vitrifier et de souder les cordons de scellement, pour assurer la cohésion mécanique et l'étanchéité de l'encapsulation.

Le procédé est, avantageusement, réalisé dans un environnement inerte, de manière à remplir les cavités, délimitées par le substrat 200, le capot 400 et le cordon de scellement 500, avec un gaz inerte. Des getters peuvent également être utilisés pour piéger l'oxygène et la vapeur d'eau. Le procédé est, par exemple, réalisé dans une boîte à gants.

### Amincissement du substrat support 200 et/ou du capot d'encapsulation 400 :

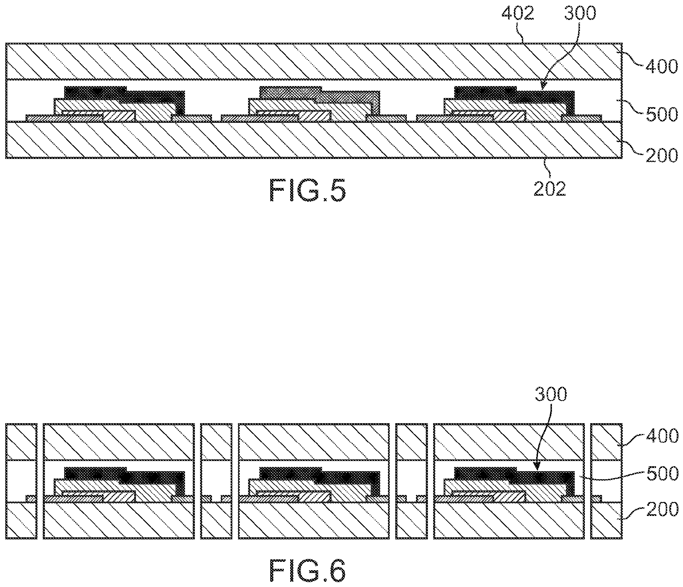

L'étape d'amincissement, réalisée lors de l'étape d), permet d'obtenir un capot et/ou un substrat ayant une épaisseur et une rugosité contrôlées (figure 5).

Selon l'invention, l'amincissement est réalisé avec une étape de gravure chimique (rectification chimique). L'un des avantages majeurs de la rectification chimique par rapport à la rectification mécanique réside dans le faible stress engendré par l'amincissement chimique.

La solution utilisée pour la gravure chimique sera choisie par l'homme du métier de manière à être adaptée pour graver la seconde face 402 capot 400 et/ou la seconde face 202 du substrat 200.

Par exemple, pour graver des éléments en silicium, il s'agira d'une solution de nature basique. La solution de gravure peut être de l'hydroxyde de potassium (KOH) à une température de 80°C permettant une vitesse de gravure de l'ordre de 1,5 µm/min. Dans le cas de l'utilisation d'une solution basique, on privilégiera des matériaux de type polysiloxanes (silicones) pour le collage de la structure de base pour leur résistance aux solutions basiques.

Pour graver des éléments en verre, on choisira une gravure de nature acide. Il peut s'agir d'une solution de gravure très concentrée en acide fluorhydrique HF (49%), d'un mélange HF avec de l'acide chlorhydrique HCl, ou encore d'un mélange entre l'HF, l'eau et de l'acide nitrique. A titre d'exemple dans le cas d'un verre alkali-free, une solution chimique comprenant un mélange équilibré avec 10% d'acide chlorhydrique (HCl) et 2% d'acide fluorhydrique (HF) permet d'avoir une vitesse de gravure standard (25°C) jusqu'à 1µm/min. Cette valeur peut être de l'ordre de 2µm/min pour une solution de gravure chauffée à 35°C. Les mélanges peuvent être ajustés afin d'augmenter la vitesse de gravure, ainsi un mélange de 10%HF et 37%HCl permet d'atteindre des vitesses de 4µm/min. On pourra atteindre des valeurs de vitesse de gravure situées entre 20 et 30 µm/min en ajustant les proportions de chaque constituant et/ou en augmentant la température.

De façon générale, les solutions de gravure peuvent être adaptées en température et en composition en fonction des matériaux à graver (silicium, verre), des épaisseurs finales recherchées et/ou des rugosités de surface souhaitées. Il est possible d'envisager une gravure chimique dans des solutions, appelées bains, en mode batch (trempage) ou par jet (douchette) en série.

Les liquides ont la composition chimique adaptée à la nature des matériaux employés dans la fabrication des substrats et des capots. Cette opération peut être réalisée de façon individuelle (une seule structure par défilement en ligne ou immersion en bain) ou de façon collective par lot de plusieurs structures à la fois.

L'étape de gravure est, avantageusement, suivie par une étape de rinçage à l'eau déionisée et par un séchage, par exemple, sous un flux d'air ou de gaz neutre. Ces séquences d'opérations rinçage/séchage peuvent être répétées de nombreuses fois jusqu'à élimination totale des résidus du mélange acide employé dans la gravure.

Lorsque le substrat support 200 et le capot d'encapsulation 400 sont en un même matériau, par exemple, en verre, une seule solution de gravure peut être utilisée pour les graver simultanément.

Lorsque le substrat support 200 et le capot d'encapsulation 400 sont en deux matériaux différents, par exemple, l'un en verre et l'autre en silicium, deux solutions de gravure différentes peuvent être utilisées successivement. Pourtant, selon l'invention le substrat support 200 et le capot d'encapsulation 400 sont toujours gravés simultanément.

L'homme du métier choisira pour la couche de collage 500 et/ou pour la couche de protection 600 un matériau résistant aux différentes solutions de gravure utilisées lors du procédé.

### Formation des contacts électriques 700 et/ou découpe du substrat 200 et/ou du capot 400 :

Après l'étape d'amincissement, une étape ultérieure dans laquelle les contacts 700 sont libérés et/ou dans laquelle les différents dispositifs microélectroniques sont séparés en élément unitaire est réalisée.

Dans un premier temps, des ouvertures sont réalisées dans le capot d'encapsulation 400 (figure 6). Cette étape peut être réalisée par toute méthode de découpe connue de l'homme du métier et adaptée aux matériaux des substrats et/ou capots. On pourra utiliser notamment une découpe mécanique à scie (« sawing ») ou encore une découpe laser (laser CO₂, laser YAG, laser picoseconde, laser femtoseconde ou laser excimer). Les ouvertures ont, par exemple, un diamètre de 100µm à 500µm.

Les ouvertures sont ensuite remplies avec un élément électriquement conducteur 700, tel qu'un métal ou un alliage de métal, ou encore une résine électriquement conductrice. Par exemple, on pourra choisir une résine à base de polymères électriquement conducteurs, telle que la résine E4110 commercialisée par la société Epo-Tek. Un traitement thermique peut ensuite être réalisé.

Il est également possible de laminer un film électriquement conducteur ou d'électrodéposer des couches électriquement conductrices dans les ouvertures.

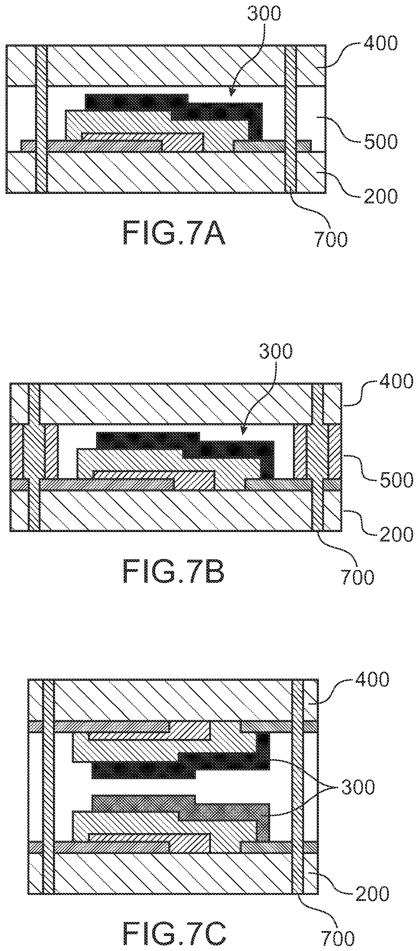

Finalement, les dispositifs microélectroniques sont séparés de façon individuelle pour obtenir des éléments unitaires (figures 7A, 7B et 7C).

Le procédé de la présente invention permet d'encapsuler de façon groupée simultanée plusieurs composants microélectroniques disposés sur un même substrat ou sur un substrat et sur un capot et, plus particulièrement, il permet d'obtenir une structure microélectronique miniaturisée comprenant un substrat et/ou un capot fin ou ultrafin.

### Exemple illustratif et non limitatif d'un mode de réalisation de l'invention :

Cet exemple concerne l'amincissement en une seule étape d'un capot d'encapsulation 400 et d'un substrat 200 rigides en verre comprenant des microbatteries au lithium 300.

### Etape 1 : Réalisation de l'empilement des microbatteries :

Plusieurs microbatteries au lithium ont été réalisées sur un substrat 200 en verre AF32 de 500µm d'épaisseur. La variation de l'épaisseur totale (ou TTV pour « Total Thickness Variation ») est de 1µm. Les microbatteries sont réalisées par des techniques connues de l'homme du métier. Les microbatteries sont positionnées à une distance D par rapport au bord du substrat rigide. La valeur minimale de la distance D est égale à deux fois l'épaisseur du substrat rigide, soit ici une valeur de 5mm.

Les collecteurs de courant sont tout d'abord déposés sur le substrat. Puis sont successivement déposés la cathode, l'électrolyte et l'anode.

La cathode est en oxyde de cobalt (LiCoO₂) d'une épaisseur de 20µm obtenue à partir d'un dépôt sous vide (PVD pour « Physical Vapor Deposition ») suivie d'un recuit thermique à 600°C pendant 10h.

L'électrolyte est une couche de 2µm d'épaisseur en LiPON.

L'électrode négative est une couche en lithium métal d'une épaisseur de 2 µm.

### Etape 2 : Dépôt de la couche de collage 500 et positionnement du capot d'encapsulation :

La couche de collage 500 est un polymère de type époxy OG198-54, de 20µm d'épaisseur, obtenue en fixant par dépôt à la tournette avec une vitesse de rotation de 1000 tr/mn pendant 40s.

Une fois, le capot d'encapsulation positionné, une force modérée F (de l'ordre de 2N) est appliquée sur le capot d'encapsulation afin de garantir un contact homogène entre la couche de collage 500 et le substrat contenant les dispositifs microbatteries. Une insolation UV est réalisée à travers le capot d'encapsulation en utilisant une dose d'environ 100mWatt/cm⁻² dans la gamme de longueur d'onde entre 280nm-800nm pendant 2mn. Puis un recuit thermique d'une durée de 20mn et à une température de 100°C est finalement réalisé.

Le capot d'encapsulation est également en verre.

### Etape 3 : Amincissement chimique de la structure de base :

La solution de gravure chimique est un mélange acide entre 10% d'HCl et 2% d'HF à 38°C. Après gravure, le substrat hôte et le capot d'encapsulation ont une épaisseur de 50 µm chacun. La tolérance en épaisseur après amincissement est typiquement inférieure à ±2%. Les surfaces amincies des verres présentent un TTV (Total Thickness Variation) dont la valeur maximale est le double de la valeur d'entrée avant amincissement. Après amincissement, le TTV est de 2µm pour les verres AF32.

### Etape 4 : Découpe de la structure de base :

La réalisation des ouvertures ainsi que la découpe en composant unitaire sont réalisées par 10 passages d'un laser picoseconde dans le visible (530 nm) à une énergie de 50 µJ.

Les ouvertures de 300µm de diamètre sont remplies par une résine conductrice E4110 commercialisé par la société Epo-Tek. Un traitement thermique à 150°C d'une durée de 15 minutes est réalisé.

Les dispositifs microélectroniques sont ensuite séparés.

## Revendications

1. Procédé d'encapsulation d'un dispositif microélectronique (300), disposé sur un substrat de support (200), avec un capot d'encapsulation (400) comprenant les étapes successives suivantes :
a) fourniture d'un substrat de support (200), en un premier matériau, comprenant une première face principale (201) sur laquelle est disposée un dispositif microélectronique (300), et une seconde face principale (202) opposée à la première face principale (201),
b) dépôt d'une couche de collage (500), en un deuxième matériau, sur la première face (201) du substrat (200), autour du dispositif microélectronique (300),
c) positionnement d'un capot d'encapsulation (400), en un troisième matériau, comprenant une première face principale (401) et une seconde face principale (402), opposée à la première face principale (401), sur la couche de collage (500), de manière à fixer la première face principale (401) du capot d'encapsulation (400) sur le substrat de support (200), et de manière à encapsuler le dispositif microélectronique (300),
d) amincissement, par gravure chimique, de la seconde face principale (202) du substrat de support (200) et de la seconde face principale (402) du capot d'encapsulation (400) jusqu'à une épaisseur inférieure à 200µm, de préférence, inférieure ou égale à 100µm et encore plus préférentiellement inférieure à 50µm,
la seconde face principale (202) du substrat de support (200) et la seconde face principale (402) du capot d'encapsulation (400) étant amincies simultanément lors de l'étape d).

2. Procédé selon la revendication précédente, **caractérisé en ce que** le premier matériau et/ou le troisième matériau sont choisis parmi le verre et le silicium.

3. Procédé selon l'une quelconque des revendications 1 et 2, **caractérisé en ce que** le premier matériau et le troisième matériau sont identiques.

4. Procédé selon l'une quelconque des revendications 1 et 2, **caractérisé en ce que** le premier matériau et le troisième matériau sont différents.

5. Procédé selon l'une quelconque des revendications 1 à 4, **caractérisé en ce que** lors de l'étape b), la couche de collage (500) recouvre totalement le dispositif microélectronique (300).

6. Procédé selon l'une quelconque des revendications 1 à 4, **caractérisé en ce que** lors de l'étape b), la couche de collage (500) forme un cordon de scellement autour du dispositif microélectronique (300).

7. Procédé selon la revendication précédente, **caractérisé en ce que** le cordon de scellement est en pâte de verre, et **en ce que** le cordon de scellement est entouré par une couche de protection (600) en un quatrième matériau.

8. Procédé selon l'une quelconque des revendications précédentes, **caractérisé en ce que** le deuxième matériau et/ou le quatrième matériau est un matériau polymère choisi parmi les époxydes, les éthers, les polysiloxanes, les acryliques, un de leurs copolymères, et le polyéthylène téraphtalate.

9. Procédé selon l'une quelconque des revendications précédentes, **caractérisé en ce que** le dispositif microélectronique (300) est un dispositif électrochimique, telle qu'une microbatterie au lithium.

10. Procédé selon l'une quelconque des revendications précédentes, **caractérisé en ce que** plusieurs dispositifs microélectroniques (300), identiques ou différents, sont disposés sur la première face (201) du substrat de support (200) et/ou sur la première face principale (401) du capot d'encapsulation (400).

11. Structure microélectronique, obtenue par le procédé selon l'une quelconque des revendications 1 à 10, comprenant un dispositif microélectronique, par exemple un dispositif électrochimique, telle qu'une microbatterie au lithium, disposé sur un substrat de support (200), en un premier matériau, ledit dispositif étant entouré par une couche de collage (500), en un deuxième matériau, sur laquelle est fixé un capot d'encapsulation (400), en un troisième matériau, le capot d'encapsulation (400) et le substrat de support (200) ayant une épaisseur inférieure à 200µm, de préférence, inférieure ou égale à 100µm, la couche de collage (500) recouvrant totalement le dispositif microélectronique (300) ou la couche de collage (500) formant un cordon de scellement, en pâte de verre, autour du dispositif microélectronique (300), le cordon de scellement étant entouré par une couche de protection (600) en un quatrième matériau.

12. Structure selon la revendication précédente, **caractérisée en ce que** le premier matériau et/ou le troisième matériau sont choisis parmi le verre et le silicium.

13. Structure selon l'une des revendications 11 et 12, **caractérisé en ce que** le capot d'encapsulation (400) et/ou le substrat de support (200) ont une épaisseur inférieure à 50µm.

## Patentansprüche

1. Verfahren zum Verkapseln einer mikroelektronischen Vorrichtung (300), die auf einem Trägersubstrat (200) angeordnet ist, mit einer Verkapselungshaube (400), das die folgenden aufeinanderfolgenden Schritte umfasst:
a) Bereitstellen eines Trägersubstrats (200) aus einem ersten Material, das eine erste Hauptseite (201), auf der eine mikroelektronische Vorrichtung (300) angeordnet ist, und eine der ersten Hauptseite (201) gegenüberliegende zweite Hauptseite (202) umfasst,
b) Abscheiden einer Klebeschicht (500) aus einem zweiten Material auf der ersten Seite (201) des Substrats (200) um die mikroelektronische Vorrichtung (300) herum,
c) Positionieren einer Verkapselungshaube (400) aus einem dritten Material, die eine erste Hauptseite (401) und eine der ersten Hauptseite (401) gegenüberliegende zweite Hauptseite (402) umfasst, auf der Klebeschicht (500) so, dass die erste Hauptseite (401) der Verkapselungshaube (400) auf dem Trägersubstrat (200) befestigt wird, und so, dass die mikroelektronische Vorrichtung (300) verkapselt wird,
d) Dünnen der zweiten Hauptseite (202) des Trägersubstrats (200) und der zweiten Hauptseite (402) der Verkapselungshaube (400) durch chemisches Ätzen bis auf eine Dicke von kleiner als 200 µm, vorzugsweise kleiner odergleich 100 µm, und noch bevorzugter kleiner als 50 µm,
wobei bei Schritt d) die zweite Hauptseite (202) des Trägersubstrats (200) und die zweite Hauptseite (402) der Verkapselungshaube (400) gleichzeitig gedünnt werden.

2. Verfahren nach dem vorstehenden Anspruch, **dadurch gekennzeichnet, dass** das erste Material und/oder das dritte Material ausgewählt sind aus Glas und Silicium.

3. Verfahren nach einem der Ansprüche 1 und 2, **dadurch gekennzeichnet, dass** das erste Material und das dritte Material identisch sind.

4. Verfahren nach einem der Ansprüche 1 und 2, **dadurch gekennzeichnet, dass** das erste Material und das dritte Material verschieden sind.

5. Verfahren nach einem der Ansprüche 1 bis 4, **dadurch gekennzeichnet, dass** bei Schritt b) die Klebeschicht (500) die mikroelektronische Vorrichtung (300) vollständig bedeckt.

6. Verfahren nach einem der Ansprüche 1 bis 4, **dadurch gekennzeichnet, dass** bei Schritt b) die Klebeschicht (500) eine Siegelnaht um die mikroelektronische Vorrichtung (300) herum bildet.

7. Verfahren nach dem vorstehenden Anspruch, **dadurch gekennzeichnet, dass** die Siegelnaht aus Glaspaste besteht, und dadurch, dass die Siegelnaht von einer Schutzschicht (600) aus einem vierten Material umgeben ist.

8. Verfahren nach einem der vorstehenden Ansprüche, **dadurch gekennzeichnet, dass** es sich beim zweiten Material und/oder dem vierten Material um ein Polymermaterial handelt, ausgewählt aus Epoxiden, Ethern, Polysiloxanen, Acrylen, einem ihrer Copolymere, und Polyethylenterephthalat.

9. Verfahren nach einem der vorstehenden Ansprüche, **dadurch gekennzeichnet, dass** es sich bei der mikroelektronischen Vorrichtung (300) um eine elektrochemische Vorrichtung, wie etwa eine Lithium-Mikrobatterie, handelt.

10. Verfahren nach einem der vorstehenden Ansprüche, **dadurch gekennzeichnet, dass** mehrere identische oder verschiedene mikroelektronische Vorrichtungen (300) auf der ersten Seite (201) des Trägersubstrats (200) und/oder auf der ersten Hauptseite (401) der Verkapselungshaube (400) angeordnet werden.

11. Mikroelektronische Struktur, die durch das Verfahren nach einem der Ansprüche 1 bis 10 erhalten wird und eine mikroelektronische Vorrichtung, zum Beispiel eine elektrochemische Vorrichtung wie etwa eine Lithium-Mikrobatterie umfasst, die auf einem Trägersubstrat (200) aus einem ersten Material angeordnet ist, wobei die Vorrichtung von einer Klebeschicht (500) aus einem zweiten Material umgeben ist, auf der eine Verkapselungshaube (400) aus einem dritten Material befestigt ist, wobei die Verkapselungshaube (400) und das Trägersubstrat (200) eine Dicke von kleiner als 200 µm, vorzugsweise kleiner oder gleich 100 µm aufweisen, wobei die Klebeschicht (500) die mikroelektronische Vorrichtung (300) vollständig bedeckt oder die Klebeschicht (500) eine Siegelnaht aus Glaspaste um die mikroelektronische Vorrichtung (300) herum bildet, wobei die Siegelnaht von einer Schutzschicht (600) aus einem vierten Material umgeben ist.

12. Struktur nach dem vorstehenden Anspruch, **dadurch gekennzeichnet, dass** das erste Material und/oder das dritte Material ausgewählt sind aus Glas und Silicium.

13. Struktur nach einem der Ansprüche 11 und 12, **dadurch gekennzeichnet, dass** die Verkapselungshaube (400) und/oder das Trägersubstrat (200) eine Dicke von kleiner als 50 µm aufweisen.

## Claims

1. A method for encapsulating a microelectronic device (300), disposed on a support substrate (200), with an encapsulation cover (400) comprising the following successive steps:
a) providing a support substrate (200), made of a first material, comprising a first main face (201) on which a microelectronic device (300) is disposed, and a second main face (202) opposite the first main face (201),
b) depositing a bonding layer (500), made of a second material, on the first face (201) of the substrate (200), around the microelectronic device (300),
c) positioning an encapsulation cover (400), made of a third material, comprising a first main face (401) and a second main face (402), opposite the first main face (401), on the bonding layer (500), so as to fix the first main face (401) of the encapsulation cover (400) on the support substrate (200), and so as to encapsulate the microelectronic device (300),
d) thinning, by chemical etching, the second main face (202) of the support substrate (200) and the second main face (402) of the encapsulation cover (400) to a thickness less than 200 µm, preferably, less than or equal to 100 µm and even more preferably less than 50 µm,
the second main face (202) of the support substrate (200) and the second main face (402) of the encapsulation cover (400) are thinned simultaneously during step d).

2. The method according to the preceding claim, **characterised in that** the first material and/or the third material are selected from glass and silicon.

3. The method according to any one of claims 1 and 2, **characterised in that** the first material and the third material are identical.

4. The method according to any one of claims 1 and 2, **characterised in that** the first material and the third material are different.

5. The method according to any one of claims 1 to 4, **characterised in that** during step b), the bonding layer (500) completely covers the microelectronic device (300).

6. The method according to any one of claims 1 to 4, **characterised in that** during step b), the bonding layer (500) forms a sealing bead around the microelectronic device (300).

7. The method according to the preceding claim, **characterised in that** the sealing bead is made of glass paste, and **in that** the sealing bead is surrounded by a protective layer (600) made of a fourth material.

8. The method according to any one of the preceding claims, **characterised in that** the second material and/or the fourth material is a polymer material selected from epoxides, ethers, polysiloxanes, acrylics, one of their copolymers, and polyethylene terephthalate.

9. The method according to any one of the preceding claims, **characterised in that** the microelectronic device (300) is an electrochemical device, such as a lithium microbattery.

10. The method according to any one of the preceding claims, **characterised in that** several identical or different microelectronic devices (300) are disposed on the first face (201) of the support substrate (200) and/or on the first main face (401) of the encapsulation cover (400).

11. A microelectronic structure, obtained by the method according to any one of claims 1 to 10, comprising a microelectronic device, for example an electrochemical device, such as a lithium microbattery, disposed on a support substrate (200), made of a first material, said device being surrounded by a bonding layer (500), made of a second material, on which is fixed an encapsulation cover (400), made of a third material, the encapsulation cover (400) and the support substrate (200) having a thickness less than 200 µm, preferably less than or equal to 100 µm and even more preferably less than 50 µm,
the bonding layer (500) completely covering the microelectronic device (300) or the bonding layer (500) forming a sealing bead, made of glass paste, around the microelectronic device (300), the sealing bead being surrounded by a protective layer (600) made of a fourth material.

12. The structure according to the preceding claim, **characterised in that** the first material and/or the third material are selected from glass and silicon.

13. The structure according to one of claims 11 and 12, **characterised in that** encapsulation cover (400) and/or the support substrate (200) having a thickness less than 50µm.
